# EUROPEAN PATENT APPLICATION

(11) **EP 1 148 649 A1**
(43) Date of publication of application: **24.10.2001**
(21) Application number: 00610041.6
(22) Date of filing: 17.04.2000
(51) Int. Cl.: H03M 7/30

(54) **Method and apparatus for data compression**

(71) Applicant: I-Data International A/S, 2880 Bagsvaerd (DK)
(72) Inventor: Videcrantz, Peter, 2900 Hellerup (DK); Jorgensen, Thomas Stage, DK-2800 Lyngby (DK)
(74) Representative: Nielsen, Henrik Sten

(57) **Abstract**

A data compression system for compressing input data and for supplying output data for transmission on a network, said data compression system comprising:
(a) an array of memory cells having an array input, an array output and defining a look-ahead buffer and a history buffer, (b) a comparator array unit having first comparator input for accessing said input data in said array of memory cells, having a second comparator unit for accessing said one or more unprocessed data elements in said look-ahead buffer, and having a comparator output, (c) a control unit having a control input for determining from said resulting data signal whether a match between parts of all of said one or more unprocessed data elements in said look-ahead buffer and parts of or all of said input data in said array of memory cells exists or no match exists, said data compression system performing continuous supply to said network of said output data.

## Description

The present invention generally relates to the technique of performing a compression of data and in particular to a data compression system, a data compression method and a data compression chip for compressing input data and for supplying output data for transmission on a network.

The most commonly applied technique for performing compression of data is the utilisation of algorithms such as an algorithm developed by Lempel and Ziv in 1977 and 1978 (LZ77) either implemented in software or hardware. The Lempel and Ziv algorithm may be implemented in hardware in several ways. One of the implementations of the LZ77 method in hardware is described in US 5,003,307, which patent hereby is incorporated by reference in present patent specification. Generally today's hardware implementations of the LZ77 method perform a compression of data in accordance with compression effect or rate. That is today's LZ77 hardware performs a compression of data so as to achieve the best compression rate possible, which compression rate is constituted by comparing the input data and the compressed data. However, these compression methods do not continuously present a stream of compressed data on an output and thus today's compression methods in effect may reduce the transmission speed when utilised for transmission of data through a network such as a local area network, wide area network or a telecommunications network. The compression methods according to today's technology do not perform a compression operation optimised in accordance with transmission rate on a network but rather in accordance with the compression rate performed on the input data. Hence today's compression methods may inflict delays in the transmission of data through a network since the input data may have any configuration and any size which subsequently determines the time needed for performing an acceptable compression according to a particular compression rate. Thus the output of compressed data varies significantly utilising the general hardware implementations of the LZ77 since the input data varies in content or configuration and varies greatly in data amount or data size and thus the output from a hardware implementation of the LZ77 method is not regularly provided.

An object of the present invention is to provide a compression of input data while concurrently and continuously providing output data.

A particular advantage of the present invention is the accomplishment of an immediate and thus effective transmission rate of output data on a network.

A particular feature of the present invention is compatibility and flexibility of the operating on one single data elements at a time or operating on a series of data elements at a time.

Another feature of the present invention is monitoring of compression of input data by continuously ensuring that only unprocessed data elements are processed by either compression or transmission of raw data.

The above object, advantage and features together with numerous other objects, advantages and features which will become evident from the below detailed description of a preferred embodiment of the present invention is according to a first aspect of the present invention obtained by a data compression system for compressing input data and for supplying output data for transmission on a network, and said data compression system comprising:
(a) an array of memory cells having an array input for receiving said input data, having a memory array output for providing access to said input data received through said array input, and defining a look-ahead buffer containing one or more unprocessed data elements of said input data and a history buffer containing one or more processed data elements of said input data,
(b) a comparator array unit having a first comparator input for connecting to said memory array output and for accessing said input data in said array of memory cells, having a second comparator input for connecting to said memory array output and for accessing said one or more unprocessed data elements in said look-ahead buffer, and having a comparator output providing a resulting data signal in accordance with a comparison of said input data with each of said one or more unprocessed data elements, and
(c) a control unit having an control input for connecting to said comparator output for receiving said resulting data signal and for determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, said control unit having a control output for providing said output data constituted by compressed data provided said control unit has identified said match and constituted by said parts of or all of said one or more unprocessed data elements provided said control unit has identified said no-match,
said data compression system controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and said data compression system performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data.

According to the basic realisation of the data compression system according to the first aspect of the present invention the data compression system initiates a transmission of output data simultaneously to receiving input data. Hence the data compression system accomplishes a continuous transmission of output data while performing a comparison between processed data and unprocessed data in the array of memory cells and unprocessed data in the look-ahead buffer. Processed data is to be construed in this context as input data, which the data compression system according to the first aspect of the present invention has performed a match upon. Processed data may either be transmitted as compressed data or uncompressed data. The processed data is transmitted as compressed data whenever the data compression system according to the first aspect of the present invention has identified a match between the contents of the received input data in the array of memory cells and transmitted as uncompressed data whenever the data compression system according to the first aspect of the present invention.

The data compression system according to the first aspect of the invention further operates in accordance with a clock for providing clock cycles so as to allow the comparator array unit to perform the comparison of the one or more unprocessed data elements with the input data and provide the resulting data signal to the control unit during one or more of the clock cycles. Hence during one clock cycle the data presented on the first comparator input accessing input data in the array of memory cells is compared with the data presented on the second comparator input accessing unprocessed data in the look-ahead buffer and the resulting data signal is provided on the comparator output. Thus a fast and accurate comparison is provided by the comparator array unit presenting a resulting data signal on the comparator output.

The data compression system according to the first aspect of the present invention may be configured to be operating on single data elements at a time or may be configured to define a data section constituted by a number of data elements of the input data in the array of memory cells. The data sections define a first data element and a last data element and the number of the data elements may be in the range of 1 to 2048 of the data elements such as ranges 1 to 1024 or 1 to 512. Preferably the data sections comprises 8 data elements, and the data elements being constituted by in the range of 1 to 64BITS such as ranges 1 to 32 or 1 to 16, preferably the data element being constituted by 8BITS. By configuring the data compression system to operate on the basis of data sections the capability of the comparison operation is significantly increased since the data compression system operating according to the clock may perform comparison of huge amounts of data configured as data sections during one clock cycle and thus perform an immediate transmission of the result of the comparison.

The data compression system according to the first aspect of the present invention may have the array of memory cells constituted by a shift register having a width in accordance with simultaneously shifting one or more of the data elements. The width being in the range 1 to 2048 data elements such as ranges 1 to 1024 or 1 to 512. Preferably the shift register has a width so as to simultaneously shift 8 data elements or shift one of the data sections. In accordance with the clock the input data are received at the array input as data sections and shifted through the shift register. The look-ahead buffer being defined by parts of the shift register containing unprocessed data sections or parts of unprocessed data sections and the history buffer being defined by parts of the shift register containing processed data sections. The width of the shift register equals the length of the data sections so that a data section received at the array input is shifted through the shift register and continuously used as basis for the comparison operation.

The array of memory cells defines a memory capacity in the range 1 BYTE to 1GBYTE such as ranges 10BYTE to 100MBYTE, 100BYTE to 10MBYTE or 1KBYTE to 1MBYTE. The memory capacity of the array of memory cells implemented by the shift register may have any size compatible with present technology, however the data compression system according to the first aspect of the invention provides the possibility of any memory capacity.

The comparator array unit according to the first aspect of the present invention comprises plurality of comparator sections, one comparator section for each of the one or more processed data elements in the history buffer, and a plurality of comparator elements in each of the plurality of comparator sections. Each of the plurality of comparator elements may have a first comparator element input and a second comparator element input connected to the memory array output for accessing a processed data element in the history buffer and/or accessing unprocessed data elements in the look-ahead buffer. The first comparator input is constituted by a plurality of the first comparator element inputs and the second comparator input is constituted by a plurality of the second comparator element inputs. Each of the plurality of comparator sections comprises a number of the comparator elements in the range 1 to 2048 comparator elements in each of the plurality of comparator sections such as ranges 1 to 1024 or 1 to 512. Preferably each of the plurality of the comparator sections comprises 8 comparator elements or as many comparator elements as number of data elements in the data sections, and each of the plurality of comparator sections defines a first comparator element, a second comparator element and a last comparator element. The plurality of comparator sections each have the first comparator element input of the first comparator element accessing a processed data element in the history buffer and each have the first comparator element input of the second through last comparator element accessing trailing data elements in the array of memory cells and has the second comparator element input of the first through last comparator elements accessing earliest received unprocessed data elements in the look-ahead buffer.. Thus the first data element in the history buffer is accessed through the first comparator element input by the first comparator element of the first comparator section connecting to the first data element in the history buffer and connecting to the trailing 7 data elements of the array of memory cells. The second data element in the history buffer is accessed through the first comparator element input of the second comparator element of the first comparator section and the second comparator section connecting to the second data element in the history buffer and connecting to the trailing 7 data elements of the array of memory cells and so on. The most recently received data element in the history buffer is accessed by the first comparator element of the last comparator section connecting the second comparator element through the last comparator elements to trailing 7 data elements of the array of memory cells that is the 7 first data elements in the look-ahead buffer. Hence each comparator section has the first comparator input of the first comparator element connecting to an associated location of the array of memory cells and has the first comparator element input of the second through last comparator elements connected to the trailing locations of the array of memory cells. Further each comparator section has the second comparator input of the first through last comparator elements connected to the look-ahead buffer for accessing the unprocessed data. This structure of comparator sections for each data element in the history buffer provides a platform for performing a comparison of matching series of data elements in the history buffer during one clock cycle and selecting that comparator section providing the earliest and best match of the series of data elements. The structure further allows for identification of a sequence of identical data sections received as input data.

The comparator array unit according to the first aspect of the present invention further during initiation of a compression session may be disabled by the control unit. The control unit may sequentially enable parts of the comparator array during the compression session in accordance with the history buffer receiving data elements from the look-ahead buffer. By disabling comparator sections or comparator elements in the comparator sections the data compression system avoids performing comparisons of invalid data in the array of memory cells. The invalid data may consist of data received during a previous compression session still in the shift register. The control unit of the data compression system may disable comparator elements or disable comparator sections.

The data compression system according to the first aspect of the present invention further comprises a first in first out buffer for receiving the input data and for communicating the input data to the look-ahead buffer through the array input maintaining a constant flow of the input data to the look-ahead buffer. Hence the data compression system may receive the input data as a serial sequence of the data elements, as a serial sequence of data sections of the data elements, or as a parallel sequence of data elements of the data elements while still utilising the first in first out buffer for providing the constant flow of the input data to the look-ahead buffer. However, the first in first out buffer receives the input data as a serial sequence of data elements and communicates the input data to the look-ahead buffer as a parallel sequence of the data sections.

The data compression system according to the first aspect of the present invention further comprises a multiplexing unit having a first multiplex input connected to the memory array output for accessing the one or more unprocessed data elements in the look-ahead buffer, having a second multiplex input connected to the control unit and having a multiplex output connected to the second comparator array input. The multiplexing unit selectively communicates the one or more unprocessed data elements in the look-ahead buffer between the memory array output and the second comparator array input and receives a multiplex control signal on the second multiplex input from the control unit. The multiplex control signal determines which of the one or more unprocessed data elements in the look-ahead buffer is communicated to the comparator array unit for performing the comparison so as to establish access for the comparator array unit to a data search section through the multiplex output. The data search section defines a first data search element and a last data element and comprises a number of data search elements in a range between 2 and 2048 data search elements such as ranges 2 to 1024 or 2 to 512. Preferably the number of data search elements in the data search section is equal to the number of data elements in the data section. The data search section presented on the multiplex output during a clock cycle comprises all data elements of a most recently received data section provided the comparator array unit has identified a match between all data elements in a preceding data search section and the input data in the array of memory cells. The data search section presented on the multiplex output during a clock cycle comprises non-matching data search elements of the preceding data search section and data elements of the most recently received data section provided the comparator array unit has identified a match between a series of one or more data search elements beginning at the first data search element of the preceding data search section and the input data in the array of memory cells. The multiplexing unit continuously provides unprocessed data element in the look-ahead buffer on the multiplexing output, thus non-matching parts of a previous data section will be presented on the multiplexing output with supplementary parts of a present data section. Hence by adding the multiplexing unit to the data compression system an excellent data selection operation is achieved.

Further, each of the plurality of comparator elements of the comparator array unit have the second comparator element input connected to the multiplex output for receiving the data search section and performing a comparison of the data search section and input data in the array of memory cells, and have a data comparator output constituting the comparator output and providing the resulting data signal in accordance with the comparison. The control unit receives the resulting data signal and determines on the basis of the resulting data signal firstly whether a match has been identified and secondly if a match has been identified which comparator section in the comparator array unit should be utilised for reference data.

The data compression system according to the first aspect of the present invention is implemented utilising semiconductor wafer technology involves planar technique, CMOS technique, thick film technique, thin film technique, SSI, LSI and VLSI technique or a combination thereof. By utilising semiconductor wafer technology a fast and reliable data compression system is implemented in both cheap and reproducible manner.

The data compression system according to the first aspect of the present invention connects to the network constituted by a local area network (LAN), a wide area network (WAN), or a mobile telecommunications network. The data compression system may be implemented for a wide variety of network types, which networks utilised electronic, magnetic, electro-magnetic, optical, or combinations thereof. Thus the network type is not limiting for the proficiency of the data compression system.
The input data according to the first aspect of the present invention is constituted by any binary format such as text format, comma or space separated variable format, any user or software-defined format, or any combinations thereof. The output data is constituted by a sequence of any binary format such as text format, comma or space separated variable format, any user or software-defined format, or any combinations thereof. The input and output data of the data compression system may thus have any binary form or for that matter any hexagonal or decimal form.

In the data compression system according to the first aspect of the present invention the data control unit comprises an encoder having a encoder input for receiving the processed data provided the comparator array unit has identified the match and the parts of or all of the most recently received data elements provided the comparator array unit has identified the no-match. The encoder further has an encoder output for supplying the output data to the network. The encoder encodes the processed data and the parts of or all of the most recently received data elements to the output data prior to transmission of the output data on the network. The encoder provides encoding of the processed data according to a compression standard or compression type used in a particular network. The data compression system allows for the implementation of any encoder performing any form of compression standard or compression type, thus providing an extremely flexible data compression system adaptable to meeting any type of encoding needs.

The control unit according to the first aspect of the present invention further comprises an arbitration unit having an arbitration input connected to the comparator output and having an arbitration output connected to the encoder input for communicating the processed data or the parts of or all of the one or more unprocessed data elements to the encoder. The arbitration unit determines the processed data on basis of the resulting data signal and provided more than one match exists between one or more of the one or more unprocessed data elements in the look-ahead buffer and the one or more processed data elements in the history buffer the arbitration unit further determines which matching part of the previously received data elements in the history buffer should utilised for the processed data. The arbitration unit generally selects between several matching comparator sections by selecting the comparator section having the longest matching part and the comparator section connected to the most recently received input data. The processed data comprises information regarding position and length in the array of memory cells of a match between data elements received at the first comparator input and the second comparator input.

The above object, advantage and features together with numerous other objects, advantages and features which will become evident from the below detailed description of a preferred embodiment of the present invention is according to a second aspect of the present invention obtained by a method for compressing input data and for supplying output data for transmission on a network, and said data compression system comprising:
(a) receiving said input data at an array input of an array of memory cells, providing access at a memory array output to said input data received through said array input, and defining a look-ahead buffer containing one or more unprocessed data elements of said input data and a history buffer containing one or more processed data elements of said input data,
(b) connecting a first comparator input of a comparator array unit to said memory array output and accessing said input data in said array of memory cells, connecting a second comparator input to said memory array output and accessing said one or more unprocessed data elements in said look-ahead buffer, and providing a resulting data signal at a comparator output in accordance with a comparison of said input data with each of said one or more unprocessed data elements,
(c) connecting an control input of a control unit to said comparator output for receiving said resulting data signal and determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, providing at a control output of said control unit said output data constituted by compressed data provided said control unit has identified said match and constituted by said parts of or all of said one or more unprocessed data elements provided said control unit has identified said no-match, and
(d) controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data.

The method according to the second aspect of the present invention comprises any of the features of the data compression system according to the first aspect of the present invention.

The above object, advantage and features together with numerous other objects, advantages and features which will become evident from the below detailed description of a preferred embodiment of the present invention is according to a third aspect of the present invention obtained by a data compression chip for compressing input data and for supplying output data for transmission on a network, and said data compression chip comprising:
(a) a housing,
(b) a plurality of connectors, and
(c) a data compression system comprising:
   (i) an array of memory cells having an array input for receiving said input data, having a memory array output for providing access to said input data received through said array input, and defining a look-ahead buffer containing one or more unprocessed data elements of said input data and a history buffer containing one or more processed data elements of said input data,
   (ii) a comparator array unit having a first comparator input for connecting to said memory array output and for accessing said input data in said array of memory cells, having a second comparator input for connecting to said memory array output and for accessing said one or more unprocessed data elements in said look-ahead buffer, and having a comparator output providing a resulting data signal in accordance with a comparison of said input data with each of said one or more unprocessed data elements, and
   (iii) a control unit having an control input for connecting to said comparator output for receiving said resulting data signal and for determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, said control unit having a control output for providing said output data constituted by compressed data provided said control unit has identified said match and constituted by said parts of or all of said one or more unprocessed data elements provided said control unit has identified said no-match,
   said data compression system controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and said data compression system performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data,

A data compression chip according to the third aspect of the present invention comprises any of the features of the data compression system according to the first aspect of the present invention and any features of the method according to the second aspect of the present invention.

Figure 1 shows a schematic diagram of the data flow involved when performing compression of data and subsequently performing data transmission of data through a data transmission controller.

Figure 2 shows a schematic diagram of a data compression system according to a first embodiment of the present invention operating on the basis of single data elements.

Figure 3 shows a schematic diagram of a data compression system according to a second and preferred embodiment of the present invention concurrently operating on the basis of one or more data elements constituted by a data section.

Figure 4 shows a schematic diagram of connections between an array of memory cells, a multiplexing unit and a comparator array unit according to the second and presently preferred embodiment of the present invention.

In the following a preferred embodiment of the present invention will be described with reference to the figures listed above.

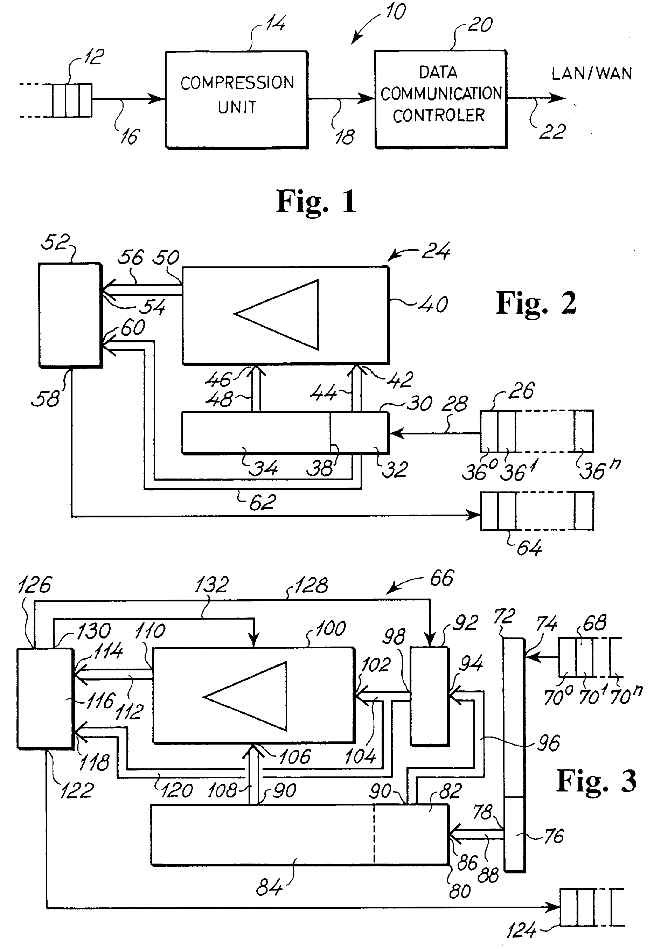

Figure 1 shows a general state of the art data processing system for compressing and transmitting of data, which data processing system is designated in its entirety by numeral 10. The data processing system 10 receives input data 12 at a compression unit 14 collecting the input data 12 through a connection 16 constituted by an optic connection, an electrical connection or alternatively by an internal bus. The compression unit 14 provides a compression of the incoming input data 12 utilising algorithms such as an algorithm developed by Lempel and Ziv in 1977 and 1978 (LZ77) either implemented in software or hardware.

There are several ways of implementing the LZ77 method in hardware e.g. as described in US 5,003,307. However, generally hardware implementations of the LZ77 method perform a compression of data during a compression time, which is proportional to the amount and configuration of data. Thus the output of compressed data will vary significantly utilising the general hardware implementations of the LZ77 since the input data varies in content or configuration and varies greatly in data amount or data size. Hence the output from a hardware implementation of the LZ77 method results in that the output is not regularly provided.

The compression unit 14 communicates compressed data through a connection 18 to a data communication controller 20 when the compression of the data is finalised. The data communication controller 20 controls transmission of the compressed data and transmits the compressed data on to a connected network 22. The network 22 may be a local area network (LAN) or a wide area network (WAN).

As the data communication controller 20 initiates a transmission on the network the data communication controller must comply with the transmission speed or transmission rate on that particular network by continuously providing transmission data on the network to achieve an efficient transmission of the data. Contrary to prior art techniques described above and described with reference to figure 1 a data compression system 24 according to a first embodiment of the present invention, shown in figure 2, continuously receives input data 26 through a connection 28 constituted by a serial or parallel electric, magnetic or optic communication cable or constituted by a internal bus system in a network controlling system or in a personal computer. The input data 26 are received in an array of memory cells 30 defining a look-ahead buffer 32 and a history buffer 34. The input data 26 is received in data sections 36° to 36^{m} and initially stored in the look-ahead buffer 32. Subsequently the input data 26 are shifted or communicated from the look-ahead buffer 32 to the history buffer 34 when the input data 26 in the look-ahead buffer has been processed. The history buffer 34 stores all the processed data received as input data 26 during a compression session. The extent of the look-ahead buffer 32 is defined by a boundary 38, which is movable in the array of memory cells 30 so as to allow the look-ahead buffer 32 to expand into the history buffer 34.

A comparator unit 40 having a first comparator input 42 connected through a first comparator link 44 to the look-ahead buffer 32 for accessing the earliest received unprocessed data of the look-ahead buffer 32 and having a second comparator input 46 connected through a second comparator link 48 to the array of memory cells 30 for accessing the received input data 26. The comparator unit 38 performs a comparison between data presented on the first comparator input 42 and the second comparator input 46. Provided the comparator unit 40 identifies a match or no match between parts of or all of the data presented on the first comparator input 42 and parts of or all of the data presented on the second comparator input 46, then the comparator unit 40 supplies a resulting data signal on a comparator output 50.

A control unit 52 having a first control input 54 connected to the comparator output 50 through a comparator link 56 receives the resulting data signal and determines on the basis of the resulting data signal whether to transmit compressed data or to transmit uncompressed data. Provided the comparator unit 40 has identified a match between the first comparator input 42 and the second comparator input 46 then the control unit 52 communicates compressed data through an output connection 58. On the other hand provided the comparator unit 40 has identified no match between the first comparator input 42 and the second comparator input 46, then the control unit 52 accesses and receives the data in the look-ahead buffer 32 presented on the first comparator input 42 on a second control input 60 through a communication link 62 and communicates the non matching parts of the data in the look-ahead buffer 32 presented on the first comparator input 42 as uncompressed data through the output connection 58. Output data 62 presented on the output connection 58 is thus constituted by the compressed data and uncompressed data.

The input data 26 constituted by the data sections 32° to 32^{m} may have any binary form such as text format, comma or space separated variable format, any user or software-defined format, or any combinations thereof. Further the data section may have any binary size from one bit to thousands of bits. Similarly the output data 56 may have any binary form such as text format, comma or space separated variable format, any user or software-defined format, or any combinations thereof, and further may have any binary size from one bit to billions of BYTES. However, generally the output data 56 has a binary size smaller than or equal to the input data 26.

In case the input data 26 comprises a sequence of identical data sections 32° to 32^{m} then the data compression system 24 will during each clock cycle present output data 64 constituted by uncompressed data during the first clock cycle and compressed data during the following clock cycles.

Figure 3 shows a schematic diagram of a data compression system according to a second embodiment of the present invention designated in its entirety by numeral 64. The data compression system 66 receives input data 68 as a sequence of data sections 70⁰,70¹ to 70^{m} in a first in first out buffer (FIFO) 72 having a FIFO input 74. The FIFO buffer 72 communicates the input data 68 in data sections 76 through a FIFO output 78. The FIFO buffer 72 may receive the input data 68 as a serial sequence of single data elements and communicate a data section whenever the FIFO buffer 72 comprises a sufficient number of data elements to constitute one data section. Alternatively the FIFO buffer 72 may receive all input data 68 before initiating a communication of data sections or receive input data 68 as large blocks of single data elements and redefine the data blocks into data sections before initiating a communication of the data sections. The data section 76 comprises a series of the data elements e.g. 2 to 2048 data elements, however the data section 76 preferably comprises 8 data elements each constituting 1 BYTE.

The FIFO 72 initiates a communication of the data section 76 whenever the FIFO 72 has received a sufficient number of data elements to fill the data section 76 and in accordance with a clock cycle.

An array of memory cells 80 defines a look-ahead buffer 82 containing unprocessed data and a history buffer 84 containing processed data. The look-ahead buffer 82 has a look-ahead buffer input 86 connected to the FIFO 72 through a first communication link 88 communicating data sections to the look-ahead buffer 82. The look-ahead buffer 82 contains a series of unprocessed data elements and provides access to the unprocessed data through a memory array output 90. The history buffer 84 receives the input data 68 through the look-ahead buffer 82 according to the clock cycle and according to whether the data compression system 66 has performed a matching process. As the data compression system performs a matching process the examined or unprocessed data in the look-ahead buffer 82 is shifted to the history buffer 84 and becomes processed data.

The term processed data in this context is to be construed as data elements, which the data compression system 66 successfully has performed a matching process upon, and the term unprocessed data in this context is to be construed as data elements, which the data compression system 66 has not performed or performed an uncompleted matching process upon.

A multiplexing unit 92 having a multiplexing input 94 connected to the memory array output 90 through a second communication link 96 for accessing the unprocessed data contained in the look-ahead buffer 82. The multiplexing unit 92 presents a data section of unprocessed data on a multiplexing output 98. The multiplexing unit 92 continuously presents the earliest received unprocessed data in the look-ahead buffer 82 on the multiplexing output 98.

A comparator unit 100 comprises a first comparator input 102 connected to the multiplexing output 98 through a third communication link 104 for accessing the earliest received unprocessed data presented on the multiplexing output 98. The comparator unit 100 further comprises a second comparator input 106 connected to the memory array output 90 through a fourth communication link 108 for accessing the processed data in the history buffer 84 and the unprocessed data in the look-ahead buffer 82. The comparator unit 100 accesses a data section for each data element of processed data in the history buffer 84. Hence provided the data compression system 66 is configured to operate using data sections comprising 8 data elements the first data element in the history buffer and the trailing 7 data elements in the look-ahead buffer 82 constitute a first data search section on the second comparator input 106 and the second data element and the first data element in the history buffer and the trailing 6 data elements in the look-ahead buffer 82 constitute a second data search section on the second comparator input 106 etc.

The comparator unit 100 performs a comparison between the data section of unprocessed data presented on the first comparator input 102 and the data sections presented on the second comparator input 106 during one clock cycle. The comparator unit 100 continuously generates and presents a resulting data signal on a comparator output 110 connected through a fifth communication link 112 to a first control unit input 114 of a control unit 116. Provided the comparator unit 100 identifies a match between parts of or all of the unprocessed data presented on the first comparator input 102 and parts of or all of the data presented on the second comparator input 106, then the comparator unit 100 communicates a resulting data signal comprising information regarding reference and length of the match in the array of memory cells 80. Alternatively, provided the comparator unit 100 does not identify a match between parts of or all of the unprocessed data presented on the first comparator input 102 and parts of or all of the data presented on the second comparator input 106, then the comparator unit 100 communicates a resulting data signal comprising information instructing the control unit 116 to access through second control unit input 118 the non matching parts of the unprocessed data presented on the first comparator input 102 through a sixth communication link 120 connecting the second control unit input 118 and the multiplexing output 98.

The control unit 100 subsequently supplies compressed data constituted by the reference and length of matching data and/or uncompressed data constituted by non matching parts of the unprocessed data presented on the first comparator input 102 on a data output 122. The compressed and/or uncompressed data are continuously presented on the data output 122 as a sequence of data sections 124 so as to present data sections on the data output 122 according to the clock cycle.

In case the comparator array 100 identifies a match for a first part of a first data section presented on the multiplexing output 98 during a first clock cycle, but the data size of the matching part of the first data section is smaller than associated resulting compressed data, then the look-ahead buffer 82 accepts a second data section from the FIFO 72 and the control unit 116 controls the multiplexing unit 92 to presents a new data section on the multiplexing output 98 constituted by the non-matching data of the first data section and additional data elements of the second data section during a second clock cycle. Thus the multiplexing unit 92 continuously supplies a data section to the first comparator input 102, which data section comprises 8 data elements constituted by remaining non matching data from the first data section supplemented by data elements from the second data section.

The control unit 116 further controls the comparator unit 100 to disable parts of the comparator unit 100 receiving invalid data on the second comparator input 106. Invalid data are supplied to the second comparator input 106 in particularly during the initial phase of a compression session since the contents of the array of memory cells 80 is not valid in respect to a new compression session. The control unit 116 has a first control output 126 providing control signals to the multiplexing unit 92 through a first control connection 128 and has a second control output 130 providing control signals to the comparator unit 100 through a second control connection 132.

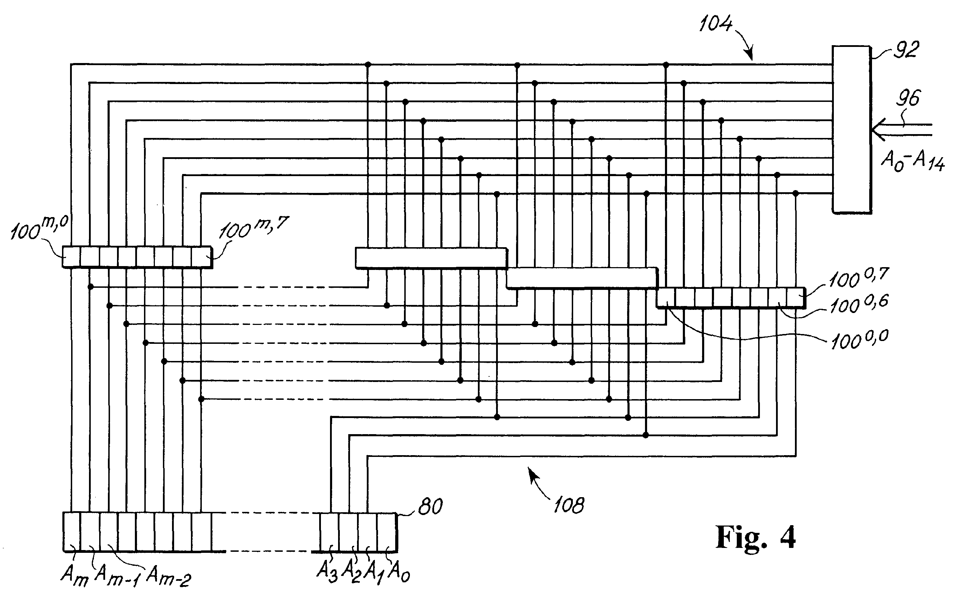

Figure 4 shows a schematic diagram of connections constituting the second, third and fourth communication links designated by numerals 96, 104 and 106 in figure 3. The comparator unit 100 comprises a plurality of comparator columns 100° to 100^{m} including a plurality of comparator elements shown in column 100° as comparator elements 100^{0,0} to 100^{0,7}. Each comparator element 100^{0,7} to 100^{m,0} has a first comparator element input connected to the multiplexing output 98 and a second comparator element input connected to the array of memory cells.

The comparator unit 100 comprises as many comparator columns 100° to 100^{m} as there are memory cells in the array of memory cells 80 and each comparator column includes one comparator element for each output terminal of the multiplexing output 98. The number of output terminals of the multiplexing output 98 is equal to the length of the data section of data elements, in the preferred embodiment of the present invention the length of the data sections is as described above 8 data elements and consequently the multiplexing output 98 has 8 output terminals. The multiplexing input 94 of the multiplexing unit 92 is connected to the array of memory cells through the first communication link 96 connecting the multiplexing input 94 with the memory cells designated by A₀ to A₁₄. The control unit 116 controls the multiplexing unit 92 to present the earliest received unprocessed data on the multiplexing output 98.

## Claims

1. A data compression system for compressing input data and for supplying output data for transmission on a network, and said data compression system comprising:
(d) an array of memory cells having an array input for receiving said input data, having a memory array output for providing access to said input data received through said array input, and defining a look-ahead buffer containing one or more unprocessed data elements of said input data and a history buffer containing one or more processed data elements of said input data,
(e) a comparator array unit having a first comparator input for connecting to said memory array output and for accessing said input data in said array of memory cells, having a second comparator input for connecting to said memory array output and for accessing said one or more unprocessed data elements in said look-ahead buffer, and having a comparator output providing a resulting data signal in accordance with a comparison of said input data with each of said one or more unprocessed data elements, and
(f) a control unit having an control input for connecting to said comparator output for receiving said resulting data signal and for determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, said control unit having a control output for providing said output data constituted by compressed data provided said control unit has identified said match and constituted by said parts of or all of said one or more unprocessed data elements provided said control unit has identified said no-match,
said data compression system controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and said data compression system performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data.

2. A data compression system according to claim 1, wherein said data compression system operates in accordance with a clock for providing clock cycles so as to allow said comparator array unit to perform said comparison of said one or more unprocessed data elements with said input data and provide said resulting data signal to said control unit during one or more of said clock cycles.

3. A data compression system according to claims 1 or 2, wherein said data compression system defining a data section constituted by a number of data elements of said input data in said array of memory cells, said data sections defining a first data element and a last data element and said number of said data elements being in the range of 1 to 2048 of said data elements such as ranges 1 to 1024 or 1 to 512, preferably said data sections comprises 8 data elements, and said data elements being constituted by in the range of 1 to 64BITS such as ranges 1 to 32 or 1 to 16, preferably said data element being constituted by 8BITS.

4. A data compression system according to any of the claims 1 to 3, wherein said data compression system receiving said input data as a serial sequence of said data elements, as a serial sequence of data sections of said data elements, or as a parallel sequence of data elements of said data elements.

5. A data compression system according to any of the claims 1 to 4, wherein said array of memory cells are constituted by a shift register having a width in accordance with simultaneously shifting one or more of said data elements, said width being in the range 1 to 2048 data elements such as ranges 1 to 1024 or 1 to 512, preferably said shift register having said width so as to simultaneously shift 8 data elements or shift one of said data sections.

6. A data compression system according to any of the claims 1 to 5, wherein said array of memory cells defining a memory capacity in the range 1 BYTE to 1GBYTE such as ranges 10BYTE to 100MBYTE, 100BYTE to 10MBYTE or 1KBYTE to 1MBYTE.

7. A data compression system according to any of the claims 1 to 6, wherein said comparator array unit comprising plurality of comparator sections, one comparator section for each of said one or more processed data elements in said history buffer, and a plurality of comparator elements in each of said plurality of comparator sections, each of said plurality of comparator elements having a first comparator element input and a second comparator element input connected to said memory array output for accessing a processed data element in said history buffer and/or accessing unprocessed data elements in said look-ahead buffer, and wherein said first comparator input is constituted by a plurality of said first comparator element inputs and said second comparator input is constituted by a plurality of said second comparator element inputs.

8. A data compression system according to claim 7, wherein each of said plurality of comparator sections comprising a number of said comparator elements in the range 1 to 2048 comparator elements in each of said plurality of comparator sections such as ranges 1 to 1024 or 1 to 512, preferably each of said plurality of comparator sections comprising 8 comparator elements or as many comparator elements as number of data elements in said data sections, and each of said plurality of comparator sections defining a first comparator element, a second comparator element and a last comparator element.

9. A data compression system according to claims 7 or 8, wherein said plurality of comparator sections each having said first comparator element input of said first comparator element accessing a processed data element in said history buffer and each having said first comparator element input of said second through last comparator element accessing trailing data elements in said array of memory cells and having said second comparator element input of said first through last comparator element accessing earliest received unprocessed data elements in said look-ahead buffer.

10. A data compression system according to any of the claims 1 to 9, wherein said comparator array unit during initiation of a compression session being disabled by said control unit and said control unit sequentially enabling parts of said comparator array during said compression session in accordance with said history buffer receiving data elements from said look-ahead buffer.

11. A data compression system according to any of the claims 1 to 10, wherein said data compression system further comprising a first in first out buffer for receiving said input data and for communicating said input data to said look-ahead buffer through said array input maintaining a constant flow of said input data to said look-ahead buffer.

12. A data compression system according to claim 11, wherein said first in first out buffer receiving said input data as a serial sequence of data elements and communicating said input data to said look-ahead buffer as a parallel sequence of said data sections.

13. A data compression system according to any of the claims 1 to 12, wherein said data compression system further comprising a multiplexing unit having a first multiplex input connected to said memory array output for accessing said one or more unprocessed data elements in said look-ahead buffer, having a second multiplex input connected to said control unit and having a multiplex output connected to said second comparator array input, said multiplexing unit selectively communicating said one or more unprocessed data elements in said look-ahead buffer between said memory array output and said second comparator array input and receiving a multiplex control signal on said second multiplex input from said control unit, which multiplex control signal determines which of said one or more unprocessed data elements in said look-ahead buffer is communicated to said comparator array unit for performing said comparison so as to establish access for said comparator array unit to a data search section through said multiplex output, said data search section defining a first data search element and a last data element and comprising a number of data search elements in a range between 2 and 2048 data search elements such as ranges 2 to 1024 or 2 to 512, preferably said number of data search elements in the data search section is equal to said number of data elements in said data section.

14. A data compression system according to claim 13, wherein said data search section presented on said multiplex output during a clock cycle comprising all data elements of a most recently received data section provided said comparator array unit has identified a match between all data elements in a preceding data search section and said input data in said array of memory cells, and wherein said data search section presented on said multiplex output during a clock cycle comprising non-matching data search elements of said preceding data search section and data elements of said most recently received data section provided said comparator array unit has identified a match between a series of one or more data search elements beginning at said first data search element of said preceding data search section and said input data in said array of memory cells.

15. A data compression system according to any of the claims 13 or 14, wherein each of said plurality of comparator elements of said comparator array unit having said second comparator element input connected to said multiplex output for receiving said data search section and performing a comparison of said data search section and input data in said array of memory cells, and having a data comparator output constituting said comparator output and providing said resulting data signal in accordance with said comparison.

16. A data compression system according to any of the claims 1 to 15, wherein said data compression system is implemented utilising semiconductor wafer technology involves planar technique, CMOS technique, thick film technique, thin film technique, SSI, LSI and VLSI technique or a combination thereof.

17. A data compression system according to any of the claims 1 to 16, wherein said network is constituted by a local area network (LAN), a wide area network (WAN), or a mobile telecommunications network.

18. A data compression system according to any of the claims 1 to 17, wherein said input data is constituted by any binary format such as text format, comma or space separated variable format, any user or software-defined format, or any combinations thereof, and wherein said output data is constituted by a sequence of any binary format such as text format, comma or space separated variable format, any user or software-defined format, or any combinations thereof.

19. A data compression system according to any of the claims 1 to 18, wherein said data control unit comprises an encoder having a encoder input for receiving said processed data provided said comparator array unit has identified said match and said parts of or all of said most recently received data elements provided said comparator array unit has identified said no-match and having an encoder output for supplying said output data to said network, said encoder encoding said processed data and said parts of or all of said most recently received data elements to said output data prior to transmission of said output data on said network.

20. A data compression system according to claim 19, wherein said control unit further comprising an arbitration unit having an arbitration input connected to said comparator output and having an arbitration output connected to said encoder input for communicating said processed data or said parts of or all of said one or more unprocessed data elements to said encoder, said arbitration unit determining said processed data on basis of said resulting data signal and provided more than one match exists between one or more of said one or more unprocessed data elements in said look-ahead buffer and said one or more processed data elements in said history buffer said arbitration unit further determining which matching part of said previously received data elements in said history buffer should utilised for said processed data.

21. A data compression system according to any of the claims 1 to 20, wherein said processed data comprises information regarding position and length in said array of memory cells of a match between data elements received at said first comparator input and said second comparator input.

22. A method for compressing input data and for supplying output data for transmission on a network, and said data compression system comprising:
(e) receiving said input data at an array input of an array of memory cells, providing access at a memory array output to said input data received through said array input, and defining a look-ahead buffer containing one or more unprocessed data elements of said input data and a history buffer containing one or more processed data elements of said input data,
(f) connecting a first comparator input of a comparator array unit to said memory array output and accessing said input data in said array of memory cells, connecting a second comparator input to said memory array output and accessing said one or more unprocessed data elements in said look-ahead buffer, and providing a resulting data signal at a comparator output in accordance with a comparison of said input data with each of said one or more unprocessed data elements,
(g) connecting an control input of a control unit to said comparator output for receiving said resulting data signal and determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, providing at a control output of said control unit said output data constituted by compressed data provided said control unit has identified said match and constituted by said parts of or all of said one or more unprocessed data elements provided said control unit has identified said no-match, and
(h) controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data.

23. A method according to claim 22, wherein said method comprises features of said data compression system according to any of the claims 2 to 21.

24. A data compression chip for compressing input data and for supplying output data for transmission on a network, and said data compression chip comprising:
(d) a housing,
(e) a plurality of connectors, and
(f) a data compression system comprising:
(iv) an array of memory cells having an array input for receiving said input data, having a memory array output for providing access to said input data received through said array input, and defining a look-ahead buffer containing one or more unprocessed data elements of said input data and a history buffer containing one or more processed data elements of said input data,
(v) a comparator array unit having a first comparator input for connecting to said memory array output and for accessing said input data in said array of memory cells, having a second comparator input for connecting to said memory array output and for accessing said one or more unprocessed data elements in said look-ahead buffer, and having a comparator output providing a resulting data signal in accordance with a comparison of said input data with each of said one or more unprocessed data elements, and
(vi) a control unit having an control input for connecting to said comparator output for receiving said resulting data signal and for determining from said resulting data signal whether a match between parts of or all of said one or more unprocessed data elements in said look-ahead buffer and parts of or all of said input data in said array of memory cells exists or no match between parts of or all of said one or more unprocessed data elements in said look-ahead buffer and parts of or all of said input data in said array of memory cells exists, said control unit having a control output for providing said output data constituted by compressed data provided said control unit has identified said match and constituted by said parts of or all of said one or more unprocessed data elements provided said control unit has identified said no-match,
said data compression system controlling said history buffer to receive said parts of or all of said one or more unprocessed data elements from said look-ahead buffer and controlling said look-ahead buffer to receive one or more new data elements of said input data replacing said parts of or all of said one or more unprocessed data elements provided said control unit has identified said match or identified said no match and said data compression system performing continuous supply to said network of said output data constituted by said compressed data provided said control unit has identified said match and constituted by said parts of or all of said one or more unprocessed data elements provided said control unit has identified said no-match so as to establish a continuous transmission of said output data on said network while concurrently performing compression of said input data,

25. A data compression chip according to claim 24, wherein said data compression chip comprises all features of said data compression system according to any of the claims 2 to 21 and all features of said method according to claims 22 or 23.
